# EUROPÄISCHE PATENTSCHRIFT

(11) **EP 0 894 338 B1**
(45) Veröffentlichungstag und Bekanntmachung des Hinweises auf die Patenterteilung: **09.04.2008**
(21) Anmeldenummer: 98912218.9
(22) Anmeldetag: 13.02.1998
(51) Int. Cl.: H01L 21/3065, H01L 21/321, H01L 21/3213

(54) **ANISOTROPES FLUORBASIERTES PLASMAÄTZVERFAHREN FÜR SILICIUM**
ANISOTROPIC, FLUORINE-BASED PLASMA ETCHING METHOD FOR SILICON
PROCEDE D'ATTAQUE CHIMIQUE PLASMATIQUE ANISOTROPE A BASE DE FLUOR POUR DU SILICIUM

(30) Priorität: 20.02.1997 DE 19706682
(43) Veröffentlichungstag der Anmeldung: 03.02.1999
(73) Patentinhaber: ROBERT BOSCH GMBH, 70442 Stuttgart (DE)
(72) Erfinder: LÄRMER, Franz, D-70437 Stuttgart (DE); SCHILP, Andrea, D-73525 Schwäbisch Gmünd (DE)
(86) Internationale Anmeldenummer: PCT/DE1998/000421
(87) Internationale Veröffentlichungsnummer: WO 1998/037577

(56) Entgegenhaltungen:
- EP-A- 0 414 372
- DE-A- 4 420 962
- US-A- 5 100 505
- US-A- 5 354 416
- US-A- 5 447 598

## Beschreibung

### Stand der Technik

Die Erfindung geht aus von einem Verfahren zum anisotropen Plasmaätzen von lateral definierten Strukturen in einem Siliciumsubstrat gemäß dem Oberbegriff des Anspruchs 1.

Das Ausbilden von Strukturen, beispielsweise Ausnehmungen in einem Siliciumsubstrat mittels des Plasmaätzverfahrens ist bekannt. Bekannt ist es auch, beispielsweise für Anwendungen in der Mikromechanik, Fluorverbindungen zum anisotropen Plasmaätzen einzusetzen. Die im Plasma erzeugten Fluorradikale agieren allerdings gegenüber Silicium isotrop, das heißt die laterale Ätzrate entspricht im wesentlichen der vertikalen, was zu entsprechend großen Maskenhinterschneidungen und abgerundeten Profilformen führt. Um mittels eines Ätzverfahrens unter Verwendung von Fluorverbindungen eine vertikale Seitenwand zu erzielen, sind zusätzlich Vorkehrungen zu treffen, um die Seitenwand selektiv vor dem Ätzangriff zu schützen und die Ätzung auf den Stukturgrund, das heißt den Boden der Ausnehmung, zu beschränken. Die Diskriminierung zwischen der Seitenwand der Ausnehmung und dem Ätzgrund kommt durch einen stark gerichteten vertikalen Einfall energetischer Ionen zustande, die neben den chemisch aktiven neutralen Radikalen gleichzeitig im Plasma produziert werden. Die Ionen treffen auf die Oberfläche des Substrates, wobei der Ätzgrund stark und die Seitenwände der Ausnehmung dagegen nur relativ schwach von Ionen bombardiert werden. Es ist bekannt, als Schutzmechanismus für die Seitenwände polymerbildende Gase wie CHF₃ einzusetzen, die direkt mit dem fluorliefernden Ätzgas gemischt werden. Aus den im Plasma vorhandenen polymerbildenden Monomeren wird eine Polymerschicht auf der Seitenwand abgeschieden, während die im Plasma produzierten Fluorradikale gleichzeitig am infolge Ioneneinfalls polymerfreien Ätzgrund das Siliciumsubstrat ätzen. Als nachteilig erweist sich, daß es im Plasma beziehungsweise auf dem Weg zum zu ätzenden Substrat zu einer intensiven Rekombination zwischen ungesättigten polymerbildenden Monomeren und den Fluorradikalen kommt. Zur Überwindung dieses Nachteils ist es bekannt, die störende Rekombination von ungesättigten polymerbildenden Monomeren und den zur Siliciumätzung fähigen Fluorradikalen zu verhindern, indem das Plasmaätzen in Ätzschritte, bei denen ausschließlich fluorliefernde Gase eingesetzt werden, und Depositionsschritte, bei denen ausschließlich Depositionsgase, wie die polymerbildenden Gase, eingesetzt werden, getrennt wird. Die beiden eingesetzten Gassorten begegnen sich aufgrund der zeitlichen Trennung ihrer Verwendung im Plasma nicht, so daß auch keine nennenswerte Rekombination erfolgen kann.

Es ist auch bekannt, die Seitenwände zu passivieren, indem im Plasma neben den ätzenden Fluorradikalen Sauerstoffradikale beziehungsweise Stickstoffradikale eingesetzt werden, die das Silicium der Seitenwand oberflächlich in Siliciumoxid beziehungsweise Siliciumnitrid umwandeln. Da die dielektrische Oberfläche durch die Fluorradikale besonders stark mit Ionenunterstützung und weniger stark ohne Ionenunterstützung geätzt wird, schreitet die Ätzung im wesentlichen auf dem Ätzgrund voran, während die Seitenwand relativ geschützt bleibt. Ein wesentlicher Nachteil dieses Verfahrens besteht darin, daß die oberflächlich erzeugten Siliciumoxid- beziehungsweise -nitridschichten nur atomare Dicken aufweisen, das heißt im Bereich von 1 nm und darunter liegen. Die oberflächlich erzeugten Siliciumoxid- beziehungsweise Siliciumnitridschichten sind daher nicht sehr dicht und bieten nur unvollständigen Schutz. Dies führt dazu, daß die Prozeßkontrolle erschwert wird beziehungsweise das Prozeßergebnis durch sekundäre Effekte stark beeinflußt wird. Die Profilformen der auszubildenden Strukturen sind nie vollständig senkrecht, da es immer Seitenwandangriffe und folglich auch Maskenrandhinterschneidungen gibt. Um die Wirksamkeit dieser Passivierung zu steigern, werden kryogene Verfahren eingesetzt, wobei durch Tiefkühlen der Siliciumsubstrate auf Temperaturen bis unter -100°C zusätzlich zur Sauerstoffpassivierung oder Stickstoffpassivierung die Seitenwandreaktion ausgefroren wird. Diese Verfahren sind im US-Patent 4,943,344 beschrieben. Als nachteilig erweist sich der hohe apparative Aufwand und die damit verbundenen Kosten, sowie die vergleichsweise geringe Zuverlässigkeit der Komponenten.

Aus der EP 0 414 372 A2 ist ein Verfahren zum Grabenätzen in Siliziumsubstraten bekannt, bei dem ein Basisgas, wie beispielsweise SiCl₄/N₂, Cl₂/N₂, etc. und ein Zusatzgas, wie beispielsweise ClF₃ oder SiF₄, zur Seitenwandpassivierung eingesetzt werden. In einem konkreten Beispiel wird eine Gasmischung von SiCl₄, N₂ und SiF₄ in einem Gasfluss-Verhältnis von 10 sccm/10 sccm/10 sccm, bei einem Prozessdruck von 0,013 Pa und bei einer Mikrowelleneinstrahlung mit einer Leistung von 850 W für einen Ätzprozess vorgeschlagen. Ein Zusatz von SiO₂-verzehrenden Gasen ist nicht vorgesehen.

### Vorteile der Erfindung

Die Erfindung betrifft ein Verfahren zum anisotropen Plasmaätzen von lateral definierten Strukturen in einem Siliciumsubstrat, wobei vor und/oder während des anisotropen Plasmaätzens auf den Seitenwänden der lateral definierten Strukturen Schutzschichten aus mindestens einer Siliciumverbindung abgeschieden werden. Dabei wird dem zum Plasmaätzen eingesetzten Ätzgas mindestens ein SiO₂-verzehrendes Gas zugesetzt.

In besonders vorteilhafter Ausgestaltung sieht die Erfindung vor, auf den Seitenwänden der lateral definierten Strukturen, insbesondere Balken, Gräben, Kämmen oder Zungen, Siliciumoxid und/oder Siliciumnitridschichten abzuscheiden. Die Strukturen sind vorzugsweise mit Hilfe einer Ätzmaske definiert. Die erfindungsgemäße Vorgehensweise führt in vorteilhafter Weise zu einer dicken, das heißt einige nm bis einige 10 nm dicken, Siliciumoxid- beziehungsweise Siliciumnitridschicht auf den Seitenwänden der Struktur. Diese Schutzschicht hält bereits bei Zimmertemperatur dem Ätzangriff der im Plasma gebildeten Radikale, insbesondere der vorzugsweise eingesetzten Fluorradikale, stand und ermöglicht damit einen besonders sicheren und störunanfälligen Ätzvorgang. In vorteilhafter Weise ist das Verfahren auch bei tieferen Substrattemperaturen durchführbar, wobei bei jeder Temperatur eines Substrates ein bestimmter Parameterbereich der Gaszusammensetzung zu verwenden ist, der zum Erhalt senkrechter Ätzprofile führt.

Die Erfindung sieht in vorteilhafter Weise vor, daß das im Plasma Fluorradikale freisetzende Ätzgas Schwefelhexafluorid SF₆ oder Stickstofftrifluorid NF₃ gegebenenfalls als Gemisch zusammen mit Argon ist. Dem die Fluorradikale liefernden Ätzgas werden zur Bereitstellung der die Schutzschicht bildenden Komponenten Oxid- und/oder Nitridbildner sowie ein sekundärer Reaktant zugefügt. Als Oxid- beziehungsweise Nitridbildner wird Sauerstoff O₂, Distickstoffoxid N₂O, ein anderes Stickoxid NO, NOₓ, Kohlendioxid CO₂, oder Stickstoff N₂ zugesetzt. In vorteilhafter Weise sieht die Erfindung bei der Verwendung von NF₃ als Ätzgas vor, keinen gesonderten Nitridbildner einzusetzen, da der bei dem Zerfall des Ätzgases NF₃ freiwerdende Stickstoff zur Nitrifizierung dient. Als sekundärer Reaktant, das heißt als die die Silicium-Komponente der Schutzschicht liefernde Verbindung, wird vorteilhafterweise Siliciumtetrafluorid SiF₄ eingesetzt. Aus dem sekundären Reaktant, also vorzugsweise SiF₄, und dem aus dem Oxid- oder Nitridbildner stammenden Reaktionspartner Sauerstoff beziehungsweise Stickstoff wird erfindungsgemäß auf der Seitenwand der Struktur das Reaktionsprodukt SiO₂, SiₓN_{y} oder eine Mischung aus SiₓO_{y}N_{z} abgeschieden. Der sekundäre Reaktant SiF₄ reagiert nicht mit den aus dem SF₆-Zerfall stammenden Fluorradikalen, sondern ausschließlich mit Sauerstoff beziehungsweise Stickstoff, wobei sogar zusätzlich Fluorradikale freigesetzt werden (SiF₄+O₂ <====> SiO₂+4 F*; SiF₄+ x O* <====> SiOₓF₄₋ₓ+ x F*).

Selbstverständlich ist es auch möglich, das erfindungsgemäße Plasmaätzen in voneinander getrennte Ätz- und Abscheideschritte zu trennen, wobei während des Ätzschrittes lediglich geätzt und während des Abscheideschrittes das vorstehend beschriebene Abscheiden der Siliciumverbindung durchgeführt wird. In besonders bevorzugter Weise werden die Ätzschritte alternierend mit den Abscheideschritten durchgeführt.

Die Affinität der erfindungsgemäß bevorzugten Oxidbeziehungsweise Nitridbildner gegenüber dem sekundären Reaktanten, also vorzugsweise SiF₄, ist gering genug, daß in der Gasphase insbesondere unter den erfindungsgemäß bevorzugten niedrigen Prozeßdrücken und den erfindungsgemäß vorgesehenen Verfahrensbedingungen, insbesondere dem Überschuß an freien Fluorradikalen im Plasma, selbst unter hochdichter Plasmaanregung keine nennenswerte Umsetzung zwischen den Oxid- beziehungsweise Nitridbildnern und dem sekundären Reaktanten stattfindet. Dadurch wird in vorteilhafter Weise vermieden, daß eine Reaktion beispielsweise eines Oxidbildners mit SiF₄ zu SiO₂ bereits in der Gasphase erfolgt, wobei der gebildete Feststoff auf die Oberfläche des Substrats herabfallen würde und dort eine Mikromaskierung mit Ätzgrundrauhigkeiten beziehungsweise Nadelbildung bewirken kann. Der erfindungsgemäß vorgesehene niedrige Prozeßdruck bewirkt durch große freie Weglängen eine Reduktion der Umsetzungswahrscheinlichkeit in der Gasphase sowie eine Reduktion von Mikroloading-Effekten bei der Siliciumätzung in schmalen Trenchgräben.

Die Erfindung führt also in vorteilhafter Weise zur Abscheidung von ätzbeständigen Siliciumverbindungen an den Seitenwänden der lateral definierten Strukturen, die als Schutzschicht wirken. Im Verlauf des erfindungsgemäßen Verfahrens treffen kontinuierlich aktivierte Siliciumfluoridverbindungen und Sauerstoff- beziehungsweise Stickstoffradikale sowie ein hoher Anteil an Fluorradikalen auf der Siliciumoberfläche auf. Dabei wird eine dicke dielektrische Schicht dort ausgebildet, wo die in vorteilhafter Weise erfindungsgemäß vorgesehene intensive Ioneneinwirkung nicht erfolgt, das heißt auf den Seitenwänden. Auf ionenbombardierten Flächen, das heißt dem Boden der Strukturen, insbesondere Ausnehmungen oder dem Ätzgrund dominiert der Einfluß der Fluorradikale und die Ätzreaktion, so daß das Siliciumsubstrat dort abgetragen wird. Die Erfindung stellt demgemäß ein Passivierungsystem für die Seitenwände lateral definierter Strukturen bereit, das ohne besondere Zusatzmaßnahmen mit den reaktiven Fluorradikalen verträglich ist.

Die Erfindung sieht in besonders vorteilhafter Ausgestaltung vor, das Verfahren mittels einer hochdichten Plasmaquelle, zum Beispiel PIE (Propagation Ion Etching), ICP (Inductive Coupled Plasma), ECR (Electron Cyclotron Resonance) durchzuführen, wodurch es ermöglicht wird, hohe Flüsse von Ätz- und Passivierspezies sowie von Ionen mit niedriger Energie einzusetzen. Dadurch wird eine hohe Ätzrate und Maskenselektivität erreicht, was letztendlich zu einem hohen Siliciumabtrag bei gleichzeitig geringem Maskenmaterialabtrag führt.

Um besonders vorteilhaft den Durchbruch von möglicherweise auf dem Ätzgrund abgeschiedenen Siliciumverbindungen, vorzugsweise SiO₂, zu beschleunigen, werden sogenannte SiO₂-verzehrende Gase wie CHF₃, C₄F₈, CF₄, C₂F₆ oder C₃F₆ dem Gasgemisch zugesetzt. Die SiO₂-verzehrenden Gase ätzen aufgrund ihres Kohlenstoffgehaltes unter gleichzeitiger Ioneneinwirkung SiO₂ besonders gut. Auf diese Weise werden ein sauberer Ätzgrund und noch höhere Ätzraten erreicht. Überdies wird eine Nadelbildung auf dem Ätzgrund vermieden. Diese Scavenger-Gase (Scavenger = oxidverzehrend) können kontinuierlich dem Plasma als konstante Beimischung zugesetzt werden, oder aber von Zeit zu Zeit oder periodisch über eine kurze Zeit eingelassen werden, um während eines solchen Flashs Oxidverunreinigungen des Ätzgrundes abzutragen.

Die Erfindung sieht in besonders vorteilhafter Weise vor, daß das Plasmaätzen unter gleichzeitiger Ioneneinstrahlung durchgeführt wird, wobei die eingesetzte Ionenenergie vorzugsweise bei 1 bis 100 eV, insbesondere bei 30 bis 50 eV liegt.

Vorzugsweise weisen die für das Plasmaätzen eingesetzten Medien Gasflüsse von 10 bis 200 sccm auf bei einem Prozeßruck von 1 bis 50 µbar (1 bar = 1 x 10⁵ Pa).

Die Erfindung sieht in einer weiteren vorteilhaften Ausgestaltung vor, die Plasmaerzeugung durch Mikrowelleneinstrahlung beziehungsweise Hochfrequenzeinstrahlung bei Leistungen von 500 bis 2000 W durchzuführen.

Die Erfindung sieht insbesondere vor, die Ionendichte, die Ionenenergie und die Relation geladener zu ungeladener Teilchen unabhängig voneinander zu regeln.

In besonders vorteilhafter Ausgestaltung sieht die Erfindung vor, den Gasfluß für SF₆ bei 20 bis 200 sccm einzustellen.

Die Erfindung sieht auch vor, den Gasfluß für SiF₄ bei 10 bis 50 sccm einzustellen.

Die Erfindung sieht in einer weiteren Ausgestaltung vor, den Gasfluß für Sauerstoff bei 10 bis 100 sccm und den Gasfluß für die SiO₂-verzehrenden Gase, insbesondere C₄F₈, bei kontinuierlichem Gasfluß bei 2 bis 10 sccm einzustellen. Bei gepulstem Scavenger-Gasfluß kann dessen Fluß höher gewählt werden, beispielsweise 30 bis 60 sccm C₄F₈ alle 30 bis 60 Sekunden einmal über 5 Sekunden Dauer. Ein Pulsen des Scavenger Flusses führt in den Prozeß kurze Reinigungsschritte ein, die bei entsprechend höherem Fluß eine kurzzeitige, intensive Reinigungswirkung entfalten, ohne die Profilform störend zu beeinflussen. Da der Scavenger nur kurzzeitig anwesend ist, kann er die Ätzprofile nicht nachteilig beeinflussen, aber trotzdem den Ätzgrund gut von Verunreinigungen befreien. Auf dem Ätzgrund werden durch intensiven Ioneneinfall Verunreinigungen rascher abgetragen, als der Scavenger den Durchbruch durch das Seitenwand(schutz)oxid schafft.

Die Erfindung sieht in einer weiteren Ausgestaltung vor, das zur Ionenbeschleunigung an der Substratelektrode eine Hochfrequenzleistung von 5 bis 50 W bereitgestellt wird, was Beschleunigungsspannungen von 20 bis 150 V entspricht.

### Zeichnungen

Die vorliegende Erfindung wird nachfolgend in Ausführungsbeispielen anhand der zugehörigen Figuren näher erläutert. Es zeigen:
- Figur 1: einen Längsschnitt durch ein Silicium-substrat mit lateralen Strukturen und
- Figur 2: eine Darstellung des Prinzips des Ätzprozesses.

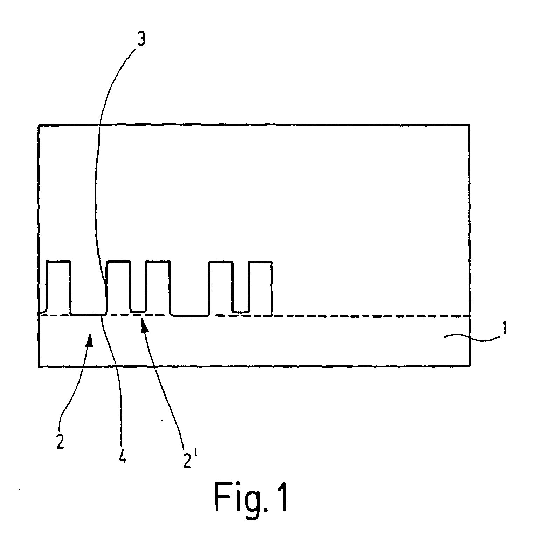

Die Figur 1 zeigt eine mittels des erfindungsgemäßen Plasmaätzverfahrens hergestellte Struktur in einem Siliciumsubstrat.

Sie zeigt ein Substrat 1 mit einer durch die Seitenwände 3 definierten Ausnehmung 2. Dargestellt ist ferner der Ätzgrund 4 sowie eine schmalere Ausnehmung 2'.

Das Verfahren zum anisotropen Plasmaätzen von lateral definierten Ausnehmungen 2, 2' in einem Siliciumsubstrat 1 wurde mit dem Ätzgas SF₆ und einem Gasfluß von 75 sccm (SF₆) durchgeführt. Als Oxidbildner wurde O₂ mit einem Gasfluß von 38 sccm und als sekundärer Reaktant SiF₄ mit einem Gasfluß von 38 sccm eingesetzt. Das Abscheiden der Schutzschicht, also der Siliciumverbindung SiO₂, geschah gleichzeitig mit dem Plasmaätzen von selbst. Die Temperatur des Substrats 1 lag bei 10°C. Der Prozeßdruck lag bei 20 µbar und die eingesetzte PIE-Quelle lieferte eine Mikrowellenleistung von 650 W (2,45 GHz). Zur Erzeugung einer Ionenbeschleunigungsspannung wurde an der Substratelektrode eine Hochfrequenzleistung von 5 W (13,56 MHz) eingesetzt, wobei die Ionenbeschleunigungsspannung (DCbias) 40 V betrug.

Die Figur 1 zeigt, daß mittels der vorstehend genannten Verfahrensbedingungen in vorteilhafter Weise senkrechte Seitenwände 3 der Ausnehmungen 2, 2' im Substrat 1 erzeugt wurden. In besonders vorteilhafter Weise ergeben sich ausgesprochen geringe Ätzratenunterschiede zwischen breiten Ausnehmungen 2 und schmaleren Ausnehmungen 2'.

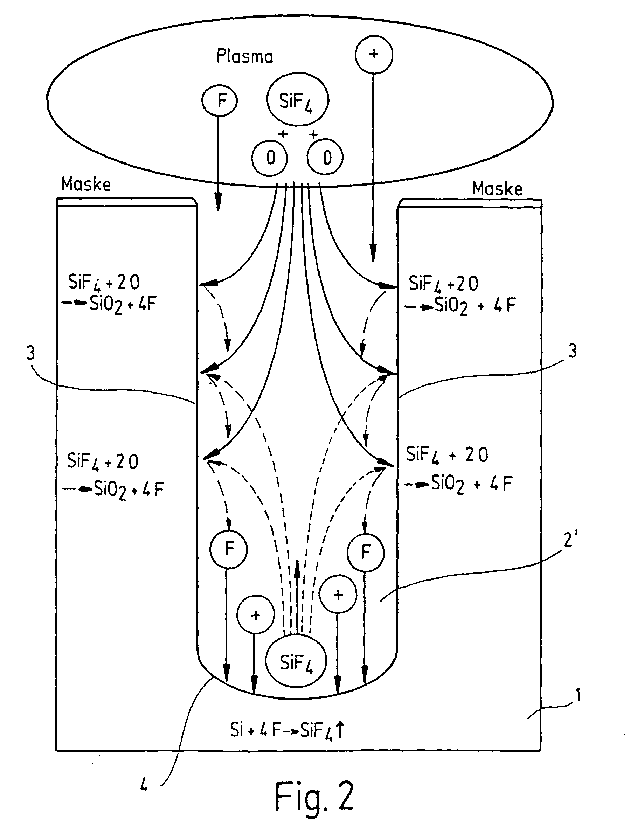

In der Figur 2 ist das Prinzip des Ätzprozesses dargestellt. Gleiche Teile sind mit denselben Bezugsziffern wie in Figur 1 versehen. Es ist ein Substrat 1 dargestellt, in das durch den Ätzprozeß eine laterale Ausnehmung 2' eingebracht wird. Für die Seitenwandpassivierung werden in das Plasma, zusätzlich zu den in diesem ausgebildeten Fluorradikalen und positiv geladenen Ionen Siliciumtetrafluorid SiF₄ und Sauerstoff eingeführt, die eine fluorverträgliche Seitenwandpassivierung gewährleisten. Am Ätzgrund 4 findet durch Ionenunterstützung die Umsetzung von Silicium und Fluorradikalen zu flüchtigem Siliciumtetrafluorid statt, welches den Ätzgrund verläßt, was die erwünschte Atzreaktion darstellt. Die Ätzung erfolgt am Ätzgrund 4 spontan und benötigt also an sich keine Ionenunterstützung. Aufgrund des starken Ioneneinfalls wird dort jedoch die Bildung von die Ätzung hemmenden Siliciumoxiden oder Oxyfluoriden unterdrückt.

An den Seitenwänden 3, die nur einem vergleichsweise geringen Ionenbombardement ausgesetzt sind, kann dagegen eine Reaktion von Siliciumtetrafluorid mit Sauerstoff zu einem die Ätzung hemmenden Siliciumoxid oder -oxyfluorid erfolgen, das sich als Film auf den Seitenwänden 3 abscheidet. Zu einem geringen Teil wird dabei das auf dem Ätzgrund gebildetete Siliciumtetrafluorid, das den Trenchgraben verlassen will, in einer Rückreaktion zur Filmbildung auf den Seitenwänden 3 verbraucht, was durch die gestrichelten Linien in Figur 2 angedeutet ist. Der wesentliche Teil des zum Seitenwandfilmaufbau benötigten Siliciumtetrafluorids wird jedoch aus der Plasmachemie geliefert, das heißt Siliciumtetrafluorid wird als das wesentliche Passiviergas zusammen mit Sauerstoff ins Plasma eingeleitet, was in der Figur 2 durch die durchgezogenen Linien gekennzeichnet ist. Wie man in Figur 2 erkennen kann, wird bei dieser Filmbildungsreaktion aus SiF₄ sogar zusätzlich Fluor freigesetzt, das zusätzlich die Ätzreaktion auf dem Ätzgrund unterstützen kann. Deswegen ist das Microloading beziehungsweise der RIE-lag, das heißt die Abnahme der Ätzrate in schmalen Trenches verglichen mit breiten, bei dieser Chemie relativ moderat ausgeprägt, da sich im Trench durch die Wandfilmbildungsreaktion zusätzliches Fluor bildet.

In einem weiteren Ausführungsbeispiel wurden unter ICP-Anregungsbedingungen (ICP: Induktiv gekoppeltes Plasma) mit Hochfrequenzanregung die nachfolgenden vorteilhaften Parameter gefunden. Die Gasflüße betrugen 40 sccm SF₆, 60 sccm O₂, 21 sccm SiF₄ und 5 sccm C₄F₈ als konstanter Gasfluß. Der Druck betrug 15 mTorr = 20 µbar und die ICP-Hochfrequenzleistung 800 W bei 13.56 Mhz, sowie die Substratleistung (Bias-Power) 10 bis 15 W bei 13.56 Mhz. Die Biasspannung wurde auf 40 bis 100 V eingestellt. Bei einem gepulsten C₄F₈-Fluß wurden folgende Gasflüsse eingestellt: 40 sccm SF₆, 60 sccm O₂, 21 sccm SiF₄, 30 - 60, vorzugsweise 45 sccm C₄F₈. Dabei wurde C₄F₈ periodisch alle 30 - 60 Sekunden, vorzugsweise alle 45 Sekunden einmal über eine Zeitdauer von 5 Sekunden zugeführt. Die ICP-Hochfrequenzleistung betrug dabei 800 W und die Substratleistung 12 W.

## Patentansprüche

1. Verfahren zum anisotropen Plasmaätzen von lateral definierten Strukturen in einem Siliziumsubstrat, wobei vor und/oder während des anisotropen Plasmaätzens auf den Seitenwänden der lateral definierten Strukturen Schutzschichten aus mindestens einer dem Siliziumsubstrat zugeführten Siliziumverbindung abgeschieden werden, **dadurch gekennzeichnet, daß** dem zum Plasmaätzen eingesetzten Ätzgas mindestens ein SiO₂-verzehrendes Gas zugesetzt wird.

2. Verfahren nach Anspruch 1, **dadurch gekennzeichnet, daß** das mindestens eine SiO₂-verzehrende Gas kontinuierlich zugesetzt wird.

3. Verfahren nach Anspruch 1, **dadurch gekennzeichnet, daß** das mindestens eine SiO₂-verzehrende Gas nur kurzzeitig und periodisch zugeführt wird.

4. Verfahren nach einem der Ansprüche 1 bis 3, **dadurch gekennzeichnet, daß** als Schutzschicht Siliziumoxid oder Siliziumnitrid oder Siliziumoxinitrid abgeschieden wird.

5. Verfahren nach Anspruch 4, **dadurch gekennzeichnet, daß** die Siliziumdxid- oder Siliziumnitridschicht aus einer dem Ätzgas zugesetzten Siliziumverbindung und Sauerstoff und/oder Stickstoff als Reaktionspartner abgeschieden wird.

6. Verfahren nach Anspruch 5, **dadurch gekennzeichnet, daß** als Reaktionspartner O₂ und/oder N₂ zugesetzt wird.

7. Verfahren nach Anspruch 5, **dadurch gekennzeichnet, daß** als Reaktionspartner O₂ und/oder N₂ aus dem Ätzgas geliefert wird.

8. Verfahren nach einem der Ansprüche 5 bis 7, **dadurch gekennzeichnet, daß** die dem Ätzgas zugesetzte Siliziumverbindung zu diesem verträglich ist, das heißt nicht mit der Ätzchemie, wohl aber mit Sauerstoff und/oder Stickstoff reagiert.

9. Verfahren nach einem der Ansprüche 5 bis 8, **dadurch gekennzeichnet, daß** die dem Ätzgas zugesetzte Siliziumverbindung SiF₄ ist.

10. Verfahren nach einem der Ansprüche 1 bis 9, **dadurch gekennzeichnet, daß** dem Ätzgas O₂, N₂O, NO, NOₓ, CO₂ oder N₂ zugesetzt wird.

11. Verfahren nach einem der Ansprüche 1 bis 10, **dadurch gekennzeichnet, daß** das zum Plasmaätzen eingesetzte Ätzgas ein fluorlieferndes Gas, vorzugsweise SF₆ oder NF₃, ist.

12. Verfahren nach einem der Ansprüche 1 bis 11, **dadurch gekennzeichnet, daß** das Plasmaätzen in voneinander getrennten Ätz- und Abscheideschritten durchgeführt wird, wobei der Ätzschritt alternierend mit dem Abscheideschritt durchgeführt wird.

13. Verfahren nach einem der Ansprüche 1 bis 12, **dadurch gekennzeichnet, daß** das Plasmaätzen unter gleichzeitiger Ioneneinstrahlung durchgeführt wird, vorzugsweise mit einer Ionenenergie von 1 - 100 eV, besonders bevorzugt von 30 - 50 eV.

14. Verfahren nach einem der Ansprüche 1 bis 13, **dadurch gekennzeichnet, daß** die für das Plasmaätzen eingesetzten Mediengasflüsse von 10 - 200 sccm und Prozeßdrücke von 1 - 50 µbar (0,1 - 5 Pa) aufweisen.

15. Verfahren nach einem der Ansprüche 1 bis 14, **dadurch gekennzeichnet, daß** das Siliziumsubstrat während des Plasmaätzens gekühlt wird.

16. Verfahren nach einem der Ansprüche 1 bis 15, **dadurch gekennzeichnet, daß** die Plasmaerzeugung durch Mikrowelleneinstrahlung, bzw. Hochfrequenzeinstrahlung bei Leistungen von 500 bis 2000 W erfolgt.

17. Verfahren nach einem der Ansprüche 1 bis 16, **dadurch gekennzeichnet, daß** die Ionendichte, die Ionenenergie und die Relation geladener (Ionen) zu ungeladenen Teilchen (Neutralspezies) unabhängig voneinander geregelt wird.

18. Verfahren nach einem der Ansprüche 11 bis 17, **dadurch gekennzeichnet, daß** als Gasfluß für Schwefelhexafluorid SF₆ 20 - 200 sccm gewählt wird.

19. Verfahren nach einem der Ansprüche 9 bis 18, **dadurch gekennzeichnet, daß** als Gasfluß für Siliziumtetrafluorid SiF₄ 10 - 50 sccm gewählt wird.

20. Verfahren nach einem der Ansprüche 5 bis 19, **dadurch gekennzeichnet, daß** als Gasfluß für Sauerstoff O₂ 10 -.100 sccm gewählt wird.

21. Verfahren nach einem der Ansprüche 1 bis 20, **dadurch gekennzeichnet, daß** als SiO₂-verzehrendes Gas CHF₃, CF₄, C₂F₆, C₃F₆ oder C₄F₈ zugesetzt wird.

22. Verfahren nach einem der Ansprüche 1 bis 21, **dadurch gekennzeichnet, daß** als Gasfluß für das mindestens eine SiO₂ -verzehrende Gas, insbesondere C₄F₈, 2 - 10 sccm gewählt wird.

23. Verfahren nach Anspruch 1 oder 3, **dadurch gekennzeichnet, daß** C₄F₈ als SiO₂-verzehrendes Gas periodisch alle 30 bis 60 s einmal über eine Zeitdauer von jeweils 5 s und mit einem Fluß von 30 - 60 sccm eingelassen wird.

## Claims

1. Method for the anisotropic plasma etching of laterally defined structures in a silicon substrate, wherein protective layers composed of at least one silicon compound fed to the silicon substrate are deposited before and/or during the anisotropic plasma etching on the sidewalls of the laterally defined structures, **characterized in that** at least one SiO₂-scavenging gas is added to the etching gas used for the plasma etching.

2. Method according to Claim 1, **characterized in that** the at least one SiO₂-scavenging gas is added continuously.

3. Method according to Claim 1, **characterized in that** the at least one SiO₂-scavenging gas is fed only briefly and periodically.

4. Method according to one of Claims 1 to 3, **characterized in that** silicon oxide or silicon nitride or silicon oxynitride is deposited as protective layer.

5. Method according to Claim 4, **characterized in that** the silicon oxide or silicon nitride layer is deposited from a silicon compound added to the etching gas and oxygen and/or nitrogen as reactant.

6. Method according to Claim 5, **characterized in that** O₂ and/or N₂ is added as reactant.

7. Method according to Claim 5, **characterized in that** O₂ and/or N₂ from the etching gas is supplied as reactant.

8. Method according to one of Claims 5 to 7, **characterized in that** the silicon compound added to the etching gas is compatible with the latter, that is to say does not react with the etching chemical, but does react with oxygen and/or nitrogen.

9. Method according to one of Claims 5 to 8, **characterized in that** the silicon compound added to the etching gas is SiF₄.

10. Method according to one of Claims 1 to 9, **characterized in that** O₂, N₂O, NO, NOₓ, CO₂ or N₂ is added to the etching gas.

11. Method according to one of Claims 1 to 10, **characterized in that** the etching gas used for the plasma etching is a fluorine-supplying gas, preferably SF₆ or NF₃.

12. Method according to one of Claims 1 to 11, **characterized in that** the plasma etching is carried out in mutually separate etching and deposition steps, when the etching step is carried out alternately with the deposition step.

13. Method according to one of Claims 1 to 12, **characterized in that** the plasma etching is carried out with simultaneous ion irradiation, preferably with an ion energy of 1-100 eV, particularly preferably of 30-50 eV.

14. Method according to one of Claims 1 to 13, **characterized in that** the media used for the plasma etching have gas flow rates of 10-200 sccm and process pressures of 1-50 µbar (0.1-5 Pa).

15. Method according to one of Claims 1 to 14, **characterized in that** the silicon substrate is cooled during the plasma etching.

16. Method according to one of Claims 1 to 15, **characterized in that** the plasma is generated by microwave irradiation, or high-frequency irradiation at powers of 500 to 2000 W.

17. Method according to one of Claims 1 to 16, **characterized in that** the ion density, the ion energy and the relation between charged (ions) and uncharged particles (neutral species) are controlled independently of one another.

18. Method according to one of Claims 11 to 17, **characterized in that** 20-200 sccm is chosen as gas flow rate for sulphur hexafluoride SF₆.

19. Method according to one of Claims 9 to 18, **characterized in that** 10-50 sccm is chosen as gas flow rate for silicon tetrafluoride SiF₄.

20. Method according to one of Claims 5 to 19, **characterized in that** 10-100 sccm is chosen as gas flow rate for oxygen O₂.

21. Method according to one of Claims 1 to 20, **characterized in that** CHF₃, CF₄, C₂F₆, C₃F₆ or C₄F₈ is added as SiO₂-scavenging gas.

22. Method according to one of Claims 1 to 21, **characterized in that** 2-10 sccm is chosen as gas flow rate for the at least one SiO₂-scavenging gas in particular C₄F₈.

23. Method according to Claim 1 or 3, **characterized in that** C₄F₈ as SiO₂-scavenging gas is periodically admitted once every 30 to 60 s for a period of 5 s in each case and with a flow rate of 30-60 sccm.

## Revendications

1. Procédé de gravure plasma anisotrope de structures définies latéralement dans un substrat de silicium, selon lequel, avant et/ou pendant la gravure plasma anisotrope, on dépose, sur les parois latérales des structures définies latéralement, des couches protectrices constituées d'au moins un composé de silicium acheminé vers le substrat de silicium,
**caractérisé en ce qu'**
on ajoute, au gaz de gravure utilisé pour la gravure plasma, au moins un gaz qui consomme du SiO₂.

2. Procédé selon la revendication 1,
**caractérisé en ce qu'**
on ajoute en continu au moins un gaz consommant du SiO₂.

3. Procédé selon la revendication 1,
**caractérisé en ce qu'**
on ajoute au moins un gaz consommant le SiO₂ uniquement pendant un court laps de temps ou périodiquement.

4. Procédé selon au moins l'une quelconque des revendications 1 à 3,
**caractérisé en ce qu'**
on dépose, à titre de couche protectrice, de l'oxyde de silicium ou du nitrure de silicium ou bien de l'oxynitrure de silicium.

5. Procédé selon la revendication 4,
**caractérisé en ce qu'**
on dépose la couche d'oxyde ou de nitrure de silicium à partir d'un composé de silicium ajouté au gaz de gravure et d'oxygène et/ou d'azote en tant que partenaire réactionnel.

6. Procédé selon la revendication 5,
**caractérisé en ce qu'**
on ajoute de l'O₂ et/ou du N₂ en tant que partenaire réactionnel.

7. Procédé selon la revendication 5,
**caractérisé en ce que**
le partenaire réactionnel fourni à partir du gaz de gravure est de l'O₂ et/ou du N₂.

8. Procédé selon l'une quelconque des revendications 5 à 7,
**caractérisé en ce que**
le composé de silicium ajouté au gaz de gravure est compatible avec celui-ci, autrement dit il ne réagit pas avec la chimie de gravure mais bien avec l'oxygène et/ou l'azote.

9. Procédé selon l'une quelconque des revendications 5 à 8,
**caractérisé en ce que**
le composé de silicium ajouté au gaz de gravure est du SiF₄.

10. Procédé selon l'une quelconque des revendications 1 à 9,
**caractérisé en ce qu'**
on ajoute au gaz de gravure de l'O₂, du N₂O, du NO, du NOₓ, du CO₂ ou du N₂.

11. Procédé selon l'une quelconque des revendications 1 à 10,
**caractérisé en ce que**
le gaz de gravure utilisé pour la gravure plasma est un gaz fournisseur de fluor, de préférence du SF₆ ou du NF₃.

12. Procédé selon l'une quelconque des revendications 1 à 11,
**caractérisé en ce que**
la gravure plasma comporte des étapes de gravure et de dépôt séparées, l'étape de gravure ayant lieu en alternance avec l'étape de dépôt.

13. Procédé selon l'une quelconque des revendications 1 à 12,
**caractérisé en ce qu'**
on procède à la gravure plasma sous irradiation simultanée d'ions, de préférence avec une irradiation ionique de 1 à 100 eV, de manière particulièrement préférée de 30 à 50 eV.

14. Procédé selon l'une quelconque des revendications 1 à 13,
**caractérisé en ce que**
le débit des gaz supports utilisés pour la gravure plasma est de 10 à 200 sccm, à des pressions de procédé de 1 à 50 µbar (0,1 à 5 Pa).

15. Procédé selon l'une quelconque des revendications 1 à 14,
**caractérisé en ce que**
le substrat de silicium est refroidi pendant la gravure plasma.

16. Procédé selon l'une quelconque des revendications 1 à 15,
**caractérisé en ce que**
le plasma est produit par rayonnement hyperfréquence respectivement haute fréquence pour des puissances de 500 à 2000 W.

17. Procédé selon l'une quelconque des revendications 1 à 16,
**caractérisé en ce que**
la densité ionique, l'énergie ionique et le rapport entre les particules chargées (ions) et les particules non chargées (espèce neutre) sont réglés indépendamment l'un de l'autre.

18. Procédé selon l'une quelconque des revendications 1 à 17,
**caractérisé en ce que**
le débit de gaz choisi pour l'hexafluorure de soufre SF₆ est de 20 à 200 sccm.

19. Procédé selon l'une quelconque des revendications 9 à 18,
**caractérisé en ce que**
le débit de gaz choisi pour le tétrafluorure de silicium SiF₄ est de 10 à 50 sccm.

20. Procédé selon l'une quelconque des revendications 5 à 19,
**caractérisé en ce que**
le débit de gaz choisi pour l'oxygène O₂ est de 10 à 100 sccm.

21. Procédé selon l'une quelconque des revendications 1 à 20,
**caractérisé en ce qu'**
comme gaz consommant du SIO₂, on ajoute CHF₃, CF₄, C₂F₆, C₃F₆ ou C₄F₈.

22. Procédé selon l'une quelconque des revendications 1 à 21,
**caractérisé en ce que**
le débit de gaz choisi pour au moins un gaz consommant du SiO₂, en particulier le C₄F₈, est de 2 à 10 sccm.

23. Procédé selon la revendication 1 ou la revendication 3,
**caractérisé en ce qu'**
on laisse entrer périodiquement toutes les 30 à 60 s, du C₄F₈ comme gaz consommant du SiO₂, une fois sur une période de 5 s et avec un débit de 30 à 60 sccm.
